# EUROPEAN PATENT APPLICATION

(11) **EP 4 239 372 A1**
(43) Date of publication of application: **06.09.2023**
(21) Application number: 23155473.4
(22) Date of filing: 08.02.2023
(51) Int. Cl.: G01S 17/89, G01S 17/894, G01S 17/86, G01S 15/86, G01S 13/86, G01S 13/88

(54) **SYSTEM AND METHOD OF COMBINING THREE DIMENSIONAL DATA**

(30) Priority: 09.02.2022 US 202263267739 P
(71) Applicant: Faro Technologies, Inc., Lake Mary, FL 32746-6204 (US)
(72) Inventor: Bergqvist, Göran, 70825 Korntal-Münchingen (DE)
(74) Representative: Müller Schupfner & Partner Patent- und Rechtsanwaltspartnerschaft mbB

(57) **Abstract**

According to one aspect of the disclosure a method for generating a three-dimensional model of an environment is provided. The method includes acquiring a first plurality of 3D coordinates of surfaces in the environment in a first coordinate frame of reference using a first measurement device, the first plurality of 3D coordinates including at least one subset of 3D coordinates of a target, the first measurement device optically measuring the plurality of 3D coordinates. A second plurality of 3D coordinates of the environment are acquired in a second frame of reference using a second measurement device, the second measurement device being operably disposed in a fixed relationship to the target. The second plurality of 3D coordinates with the first plurality of 3D coordinates are registered in the first coordinate frame of reference based at least in part on the at least one subset of 3D coordinates and the fixed relationship.

## Description

### CROSS-REFERENCE TO RELATED APPLICATIONS

The present application is a nonprovisional application of, and claims the benefit of, United States Provisional Application Serial No. 63/267739 filed on February 9, 2022, the contents of which is incorporated by reference herein in its entirety.

### BACKGROUND OF THE DISCLOSURE

The subject matter disclosed herein relates to a system and method of combining data, and in particular to combining measured physical properties into a three-dimensional point cloud in a common coordinate frame of reference.

Three-dimensional (3D) scanners are often used to measure and create a digital model of an environment. Typically, the 3D scanner emits a beam of light, such as laser light, that strikes a surface in the environment and at least a portion of the light is reflected back to the 3D scanner. Based on the time it takes the light beam to travel to the surface and back allows the 3D scanner to determine the distance to the surface. The 3D scanners include sensors, such as rotary encoders for example, that determine the direction the beam of light was emitted. Based on the distance and the sensors, the three-dimensional coordinates of the point on the surface can be determined in the local frame of reference of the 3D scanner. The collection of three-dimensional coordinates is commonly referred to as a point cloud

Sensors measure physical parameters environment are typically one-dimensional or two-dimensional in nature. For example, measuring temperature may be performed by a thermal or infrared camera that acquires a pictures (two-dimensions) of temperature. Other thermal sensors, such as thermocouples, measure temperatures at a point.

The combining of physical parameters with point cloud data is desirable as it better allows a user to visualize the distribution of the measured parameters in the environment. It should be appreciated that due differences how the sensor data is acquired, such as in number of dimensions and resolution for example, it is difficult to combine this disparate data.

Accordingly, while existing measurement systems are suitable for their intended purpose the need for improvement remains, particularly in having a system and method having the features described herein.

### BRIEF DESCRIPTION OF THE DISCLOSURE

According to one aspect of the disclosure a method for generating a three-dimensional (3D) model of an environment is provided. The method includes acquiring a first plurality of 3D coordinates of surfaces in the environment in a first coordinate frame of reference using a first measurement device, the first plurality of 3D coordinates including at least one subset of 3D coordinates of a target, the first measurement device optically measuring the plurality of 3D coordinates. A second plurality of 3D coordinates of the environment are acquired in a second frame of reference using a second measurement device, the second measurement device being operably disposed in a fixed relationship to the target. The second plurality of 3D coordinates with the first plurality of 3D coordinates are registered in the first coordinate frame of reference based at least in part on the at least one subset of 3D coordinates and the fixed relationship.

In addition to one or more of the features described herein, or as an alternative, further embodiments of the method may include the second measurement device is a sonar measurement device that is rigidly coupled to and offset from the target.

In addition to one or more of the features described herein, or as an alternative, further embodiments of the method may include: the target is fixed to a ground surface in the environment; the second measurement device is a ground penetrating radar device that is configured to measure a distance to the target when the ground penetrating radar is moved over the target; and the fixed relationship is the distance.

In addition to one or more of the features described herein, or as an alternative, further embodiments of the method may include the second plurality of 3D coordinates includes a physical parameter of the environment measured by the ground penetrating radar.

In addition to one or more of the features described herein, or as an alternative, further embodiments of the method may include the first frame of reference is a geodetic frame of reference and the first measurement device is one of a theodolite, a total station, a laser tracker or a laser scanner.

In addition to one or more of the features described herein, or as an alternative, further embodiments of the method may include the second measurement device is a sound pressure camera and the target includes a tone generator.

In addition to one or more of the features described herein, or as an alternative, further embodiments of the method may include the acquiring of the second plurality of 3D coordinates includes: generating sound at a predetermined frequency and level with the tone generator; acquiring a third plurality of 3D coordinates of the target in the second coordinate frame of reference with the sound pressure camera based on the sound; acquiring a fourth plurality of 3D coordinates of the environment in the second coordinate frame of reference with the sound pressure camera, at least a portion of the fourth plurality of 3D coordinates having an associated sound pressure level value; and registering the third plurality of 3D coordinates and the fourth plurality of 3D coordinates in the second frame of reference.

In addition to one or more of the features described herein, or as an alternative, further embodiments of the method may include the target is includes a base having a retaining element.

In addition to one or more of the features described herein, or as an alternative, further embodiments of the method may include: coupling a marker to the retaining element prior to acquiring the first plurality of 3D coordinates; removing the marker from the retaining element and coupling the tone generator to the retaining element prior to acquiring the third plurality of 3D coordinates; and deactivating the tone generator prior to acquiring the fourth plurality of 3D coordinates.

According to one aspect of the disclosure a method for generating a three-dimensional (3D) model of an environment is provided. The method comprising: providing a first measurement device configured to optically measuring a plurality of 3D coordinates; acquiring the first plurality of 3D coordinates in a first coordinate frame of reference using the first measurement device, the first plurality of 3D coordinates including at least one subset of 3D coordinates of a target; providing a second measurement device configured to measure a second plurality of 3D coordinates that include at least one physical parameter; disposing the second measurement device in a fixed relationship to the target; acquiring the second plurality of 3D coordinates in a second frame of reference using the second measurement device; and registering the second plurality of 3D coordinates with the first plurality of 3D coordinates in the first coordinate frame of reference based at least in part on the at least one subset of 3D coordinates and the fixed relationship.

In addition to one or more of the features described herein, or as an alternative, further embodiments of the method may include the second measurement device being a sonar measurement device that is rigidly coupled to and offset from the target.

In addition to one or more of the features described herein, or as an alternative, further embodiments of the method may include the target being fixed to a ground surface in the environment; the second measurement device is a ground penetrating radar device that is configured to measure a distance to the target when the ground penetrating radar is moved over the target; and the fixed relationship is the distance.

In addition to one or more of the features described herein, or as an alternative, further embodiments of the method may include the physical parameter being measured by the ground penetrating radar.

In addition to one or more of the features described herein, or as an alternative, further embodiments of the method may include the first frame of reference being a geodetic frame of reference and the first measurement device is one of a theodolite, a total station, a laser tracker or a laser scanner.

In addition to one or more of the features described herein, or as an alternative, further embodiments of the method may include the second measurement device being a sound pressure camera and the target includes a tone generator.

In addition to one or more of the features described herein, or as an alternative, further embodiments of the method may include the acquiring of the second plurality of 3D coordinates including: generating sound at a predetermined frequency and level with the tone generator; acquiring a third plurality of 3D coordinates of the target in the second coordinate frame of reference with the sound pressure camera based on the sound; acquiring a fourth plurality of 3D coordinates of the environment in the second coordinate frame of reference with the sound pressure camera, at least a portion of the fourth plurality of 3D coordinates having an associated sound pressure level value; and registering the third plurality of 3D coordinates and the fourth plurality of 3D coordinates in the second frame of reference.

In addition to one or more of the features described herein, or as an alternative, further embodiments of the method may include the target having a base having a retaining element.

In addition to one or more of the features described herein, or as an alternative, further embodiments of the method may include coupling a marker to the retaining element prior to acquiring the first plurality of 3D coordinates; removing the marker from the retaining element and coupling the tone generator to the retaining element prior to acquiring the third plurality of 3D coordinates; and deactivating the tone generator prior to acquiring the fourth plurality of 3D coordinates.

These and other advantages and features will become more apparent from the following description taken in conjunction with the drawings.

### BRIEF DESCRIPTION OF DRAWINGS

The subject matter, which is regarded as the disclosure, is particularly pointed out and distinctly claimed in the claims at the conclusion of the specification. The foregoing and other features, and advantages of the disclosure are apparent from the following detailed description taken in conjunction with the accompanying drawings in which:
FIG. 1A is a schematic perspective illustration of a system for measuring a structure over a body of water in accordance with an embodiment;
FIG. 1B is a perspective illustration of a bridge support having measurement devices in accordance with an embodiment;
FIG. 1C is a schematic illustration of a base and sensor system for measuring physical parameters underwater in accordance with an embodiment;
FIG. 1D is a flow diagram showing a method of measuring a structure over a body of water;
FIG. 2A is a perspective view of an environment being measured using ground penetrating radar in accordance with an embodiment;
FIG. 2B is a plan view of the environment of FIG. 2A;
FIG. 2C is a schematic side view of the environment of FIG. 2A being measured by ground penetrating radar in accordance with an embodiment;
FIG. 2D is a aerial view of the environment of FIG. 2A with the ground penetrating radar data combined with a point cloud in accordance with an embodiment;
FIG. 2E is a flow diagram showing a method of measuring an environment with ground penetrating radar;
FIG. 3A is a facility that uses automated guided vehicles (AGV) in accordance with an embodiment;
FIG. 3B is a schematic illustration of an AGV within the facility of FIG. 3A in accordance with an embodiment;
FIG. 3C is a flow diagram showing a method of localizing an AGV within the facility of FIG. 3A in accordance with an embodiment;
FIG. 4A is a sound pressure level image of a tone generator acquired by a sound pressure measurement device in accordance with an embodiment,
FIG. 4B is a sound pressure level image of a device in accordance with an embodiment;
FIG. 4C is a flow diagram showing a method of measuring an environment and incorporating sound pressure data in accordance with an embodiment; and
FIG. 5A - 5D are views of a laser scanner in accordance with an embodiment.

The detailed description explains embodiments of the disclosure, together with advantages and features, by way of example with reference to the drawings.

### DETAILED DESCRIPTION OF THE DISCLOSURE

Embodiments of the present disclosure provide for a system and method for generating a digital or electronic model of an environments, sometimes referred to as a "digital twin" for example, that includes measured physical parameters such an temperature, density or sound pressure level for example. Further embodiments provide for the generation of a more complete digital twin by combining different measurements, such as a laser scan and a sonar scan into a single model.

A digital twin is an electronic model of an environment, such as but not limited to a facility, a manufacturing environment, construction sites, an archeological site, or an accident scene for example. Generally, the digital twin is in the form of a collection of three-dimensional (3D) coordinates of surfaces in the environment (walls, floors, ceilings, machines, fixtures, etc.) that are graphically represented as points. This collection of 3D coordinates is sometimes referred to as a "point cloud." In some embodiments, the point cloud is then processed to form (digital) surfaces, such as by generating a mesh for example. It should be appreciated that the generation of surfaces allows the displaying of the digital twin to allow the user to view the environment in a realistic manner.

The digital twin may be generated using any traditional 3D coordinate measurement process, such as but not limited to time of flight laser scanners, triangulation scanners, or photogrammetry systems for example.

The digital twin may be used for a variety of use cases. In a manufacturing context, the user may use the digital twin to plan changes to the manufacturing lines or equipment for example, and have a high level of confidence that the planned changes will work. In many situations, the user will need to consult multiple data sets in order to make a plan. For example, at construction site the user may have to use the digital twin along with other measurements, such as readings from ground penetrating radar or sonar for example, to get a more complete view of the environment in which the planned activities will take place. It should be appreciated that it is desirable to have all of the data needed by the user in a single electronic model.

One issue that arises is that the different data sets are not generated in the same frame of reference. For example, the laser scanner measures points in the environment in a first frame of reference. Since the laser scanner can only measure points that are within a line of sight of the scanner, blocked areas, such as underwater areas or underground areas for example, cannot be scanned. These areas may be measured using other devices, such as sonar devices or ground penetrating radar for example. The devices measure the blocked areas in a different frame of reference, at a different resolution, or a combination thereof. As a result, the combining of the laser scanner measurements and the other measurement devices is at best a labor intense and manual process. Accordingly, it is desirable to provide a system that allows for automated or semi-automated combining of 3D coordinate models with a first measurement device (e.g. a laser scanner, photogrammetry devices) with models from a second measurement device (e.g. sonar, ground penetrating radar, sound cameras).

In accordance with an embodiment, a target device 100 is provided that is configurable to be measured by both a first 3D coordinate measurement device (e.g. a laser scanner) and a second measurement device. In an embodiment, the target device 100 includes a base member having a retaining element. The base member is configured to be attached to a surface in the environment. The retaining element allows for different devices or objects to be attached to the base member. As will be discussed in more detail herein, the devices attachable to the base may include, but are not limited to, spherical markers, checkerboard markers, retroreflective markers, sonar devices, tone generators, or machine readable symbols for example. In an embodiment, the target device may be similar to that described in commonly owned United States Patent 10,508,915 or United States Patent 10,360,722, the contents of both of which are incorporated by reference herein.

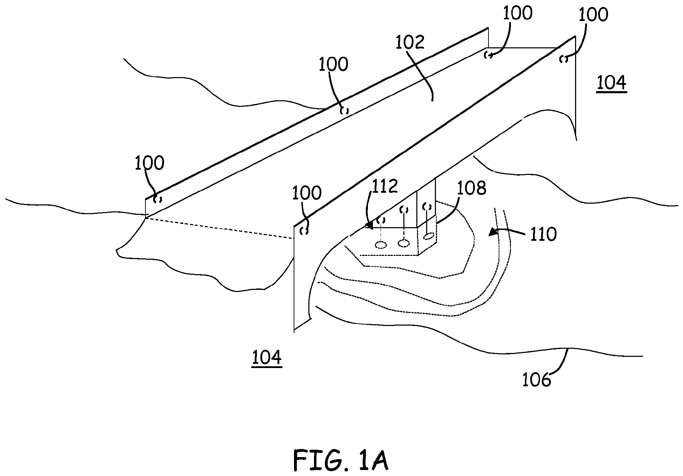

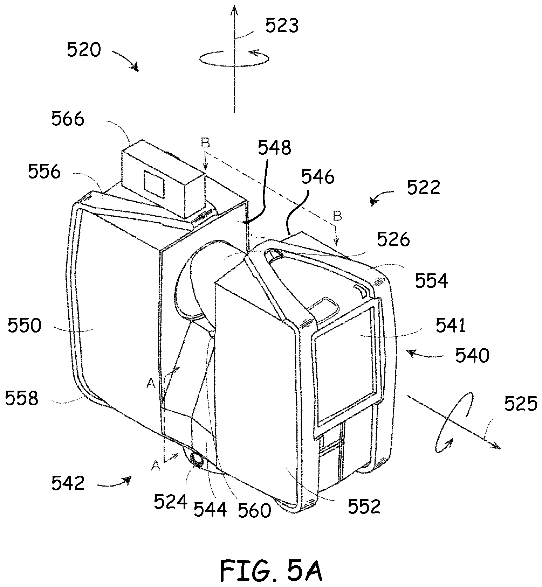

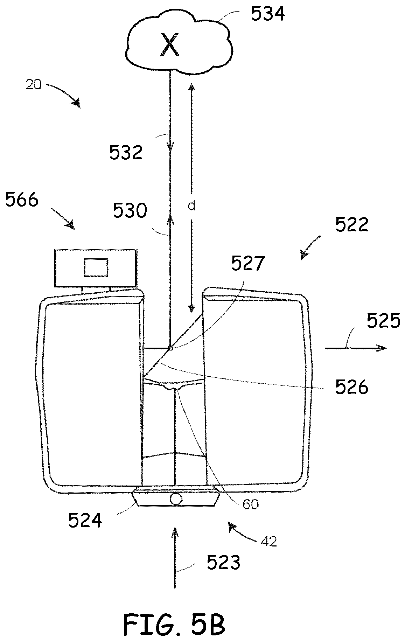

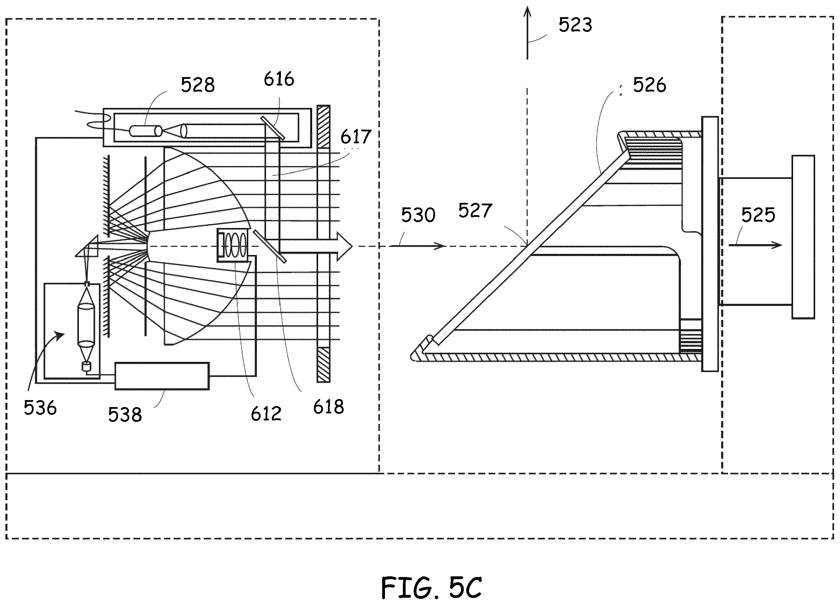

Referring now to FIG. 1A, an embodiment is shown of a bridge 102 where it is desired to have a digital twin of both the bridge 102 and surrounding environment 104 above water 106 along with the underwater bridge structure 108 and adjacent environment 110. It should be appreciated that a terrestrial laser scanner, such as laser scanner 500 shown and described with respect to FIGS. 5A-5D for example, can measure the bridge 102 and environment 104. As is known in the art, multiple terrestrial scans may be performed by the laser scanner to obtain a scan of the bridge 102 and environment 104 with few or no occlusions. It should be appreciated however, that the measurement of the underwater structures 108 and environment 110 by the terrestrial laser scanner will be, at best, erroneous. The reason is that the surface of the water and the water itself will deflect the beam of light and also change the time of flight. Even non-laser based measurement devices such as photogrammetry devices will generate erroneous data due to the refraction of light by the water.

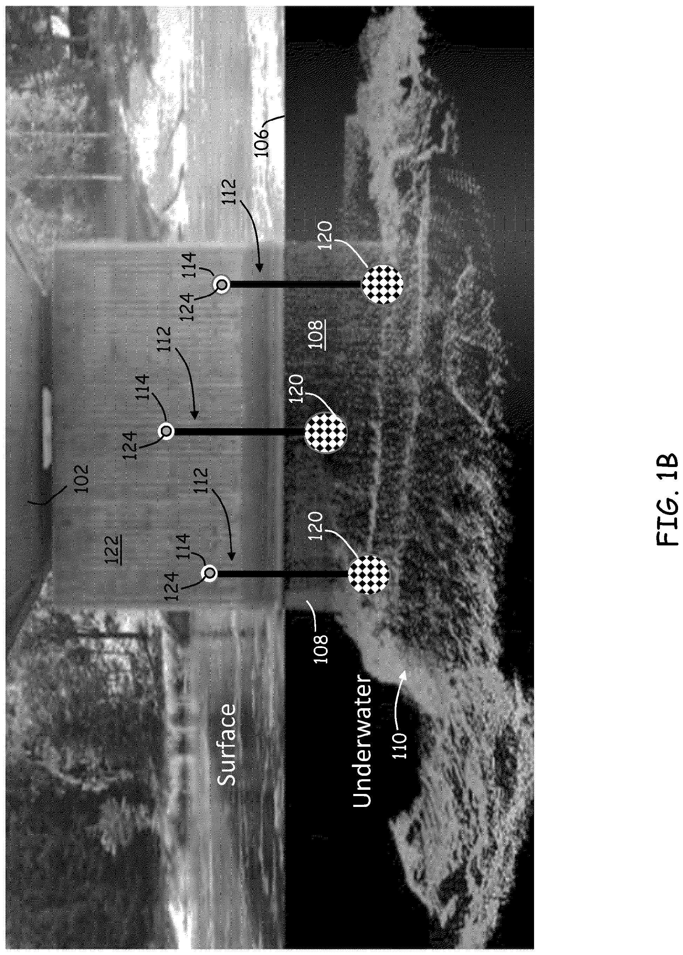

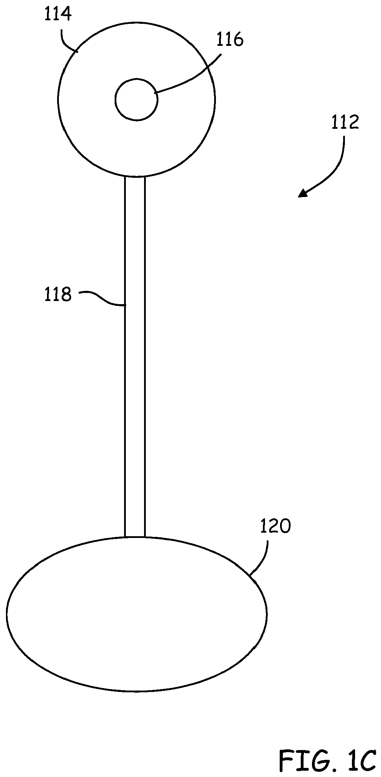

In an embodiment, one or more targets 112 are provided. As shown in FIGS. 1B, 1C, the target 112 includes a base member 114 having a retaining element 116. The retaining element 116 may be any suitable mechanism that can repeatedly attach a device, such as a checkerboard marker for example, in a predetermined relationship to the base member 114. In an embodiment, the marker is fixed to the base member 114 and not removable. Extending from the base member 114 is a spacer 118 having a sonar transponder 120 disposed on an opposite end from the base member 114. The spacer 118 holds the sonar device 120 in a predetermined fixed relationship relative to the base member 114. The sonar device 120 may be either an active device (e.g. a transponder) or a passive device (e.g. a receiver). In an embodiment, a second base member 114A and retaining element 116A (FIG. 1C) may be used to determine the distance between the base member 114 and the sonar transponder 120 when other external orientation measurements are not used. In an embodiment the sonar transponder 120 includes a sound transmitter and a receiver. In the exemplary embodiment, the sonar transponder 120 uses active sonar by emitting pulses of sounds (from the transmitter) and listening (with the receiver) for the echoes, This uses acoustic location to measure the location of underwater targets such as the river bed 110.

In operation, the targets 112 are coupled to the bridge structure 122 that is above the underwater structure 108. In this way, the base member 114 and the marker 124 are positioned above the waterline 106. In this way the marker 124 maybe measured by the laser scanner when the bridge 102 is measured. When the sonar transponder 120 acquires 3D coordinates of the underwater structure 108 and the underwater environment 110, the 3D coordinates are in the local frame of reference of the sonar transponder 120. It should be appreciated that since the sonar transponder 120 is held in a predetermined fixed geometric relationship to the base member 114, the location of the sonar device 120 in the coordinate frame of reference of the laser scanner is known. Therefore, the 3D coordinates acquired by the sonar transponder 120 in the local (sonar device) frame of reference may be transformed into the laser scanner frame of reference.

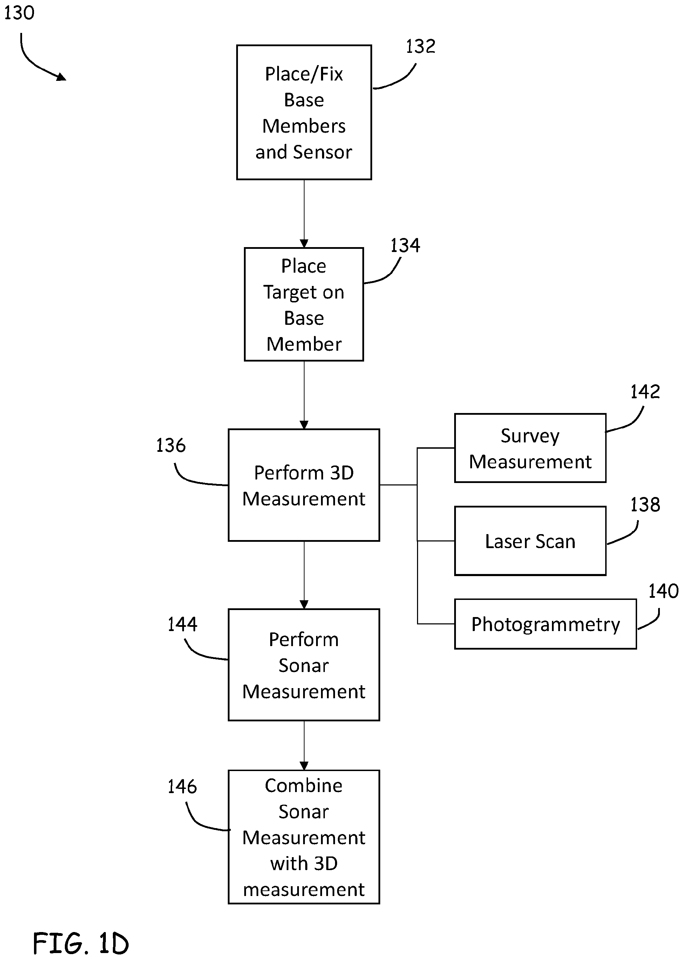

Referring now to FIG. 1D a method 130 is shown of combining sonar measurement data with point cloud data. The method 130 starts in block 132 where the Targets 100 (if needed) and the transponder 120 are placed in the environment to be scanned. As discussed above, the base member 114 is placed in a location where the marker 124 is measurable by the 3D coordinate measurement device. If not already in place the marker 124 is placed on the base member 114 in block 134.

The method 130 then proceeds to block 136 where the first plurality of 3D coordinates of surfaces located above the waterline are measured. This measurement may be performed by a suitable measurement device such as a laser scanner 138 or a photogrammetry device 140. In some embodiments, the measurements may be performed by a suitable surveying device 142, such as a total station or a theodolite for example. The method 130 then proceeds to block 144 where the sonar measurements are made by sonar transponder 120. With the second plurality of 3D coordinates acquired, the method 130 proceeds to block 146 where the second plurality of 3D coordinates are transformed from the local frame of reference to the frame of reference of the first plurality of 3D coordinates.

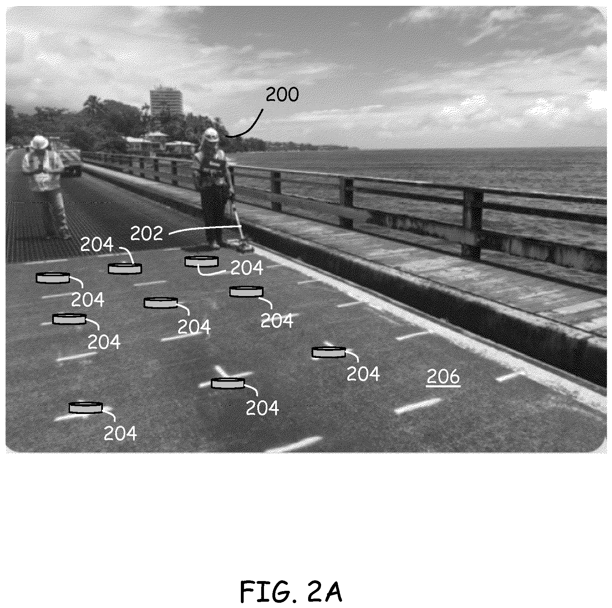

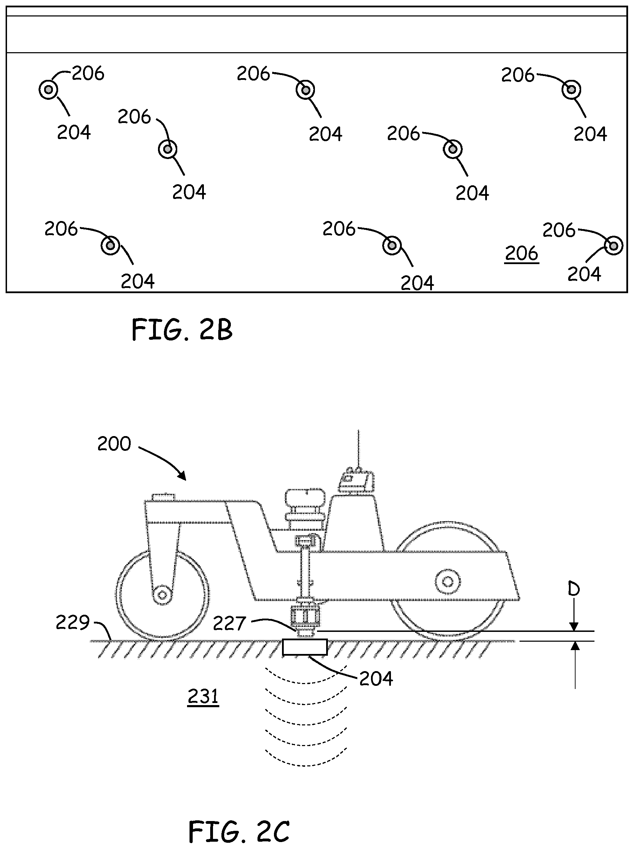

Referring now to FIGS. 2A - 2D, another embodiment is shown for merging measurement data from a ground penetrating radar with a point cloud. In this embodiment the operator 200 of the ground penetrating radar system 202 places and fixes the target 204 on or in the ground 206. As will be discussed in more detail, the targets 204 include a base member are made from a material having a density greater than the density of the adjacent ground so that the base member is distinguishable from the ground in the radar data. Coupled to the target 206 is a marker, such as a spherical checkerboard or a retroreflector. The marker 206 is configured to allow it to be measured by a measurement device, such as but not limited to a laser scanner, a laser tracker, a total station or a theodolite for example.

Ground penetrating radar (GPR) systems operate by transmitting electromagnetic radiation in the radio spectrum into the ground and detects reflected signals of subsurface structures. It may be used for surveying subsurface utilities such as pipes, cables, concrete, and asphalt for example. Generally, the GPR system is moved across the target area along straight lines. In an embodiment, the GPR system is arranged on a mobile device, such as a trolley, a cart, or a vehicle for example, which allows the GPR system to be moved along a trajectory or path. In an embodiment, the continuous positioning along the path or trajectory of the GPR system, such as one moved by a trolley for example, may be assisted by using a global positioning system (GPS) operably coupled to the GPR system (i.e. on the trolley). By systematically moving the GPR system along multiple measurement lines, the lines of measured data may be combined to define a 3D image of the subsurface environment.

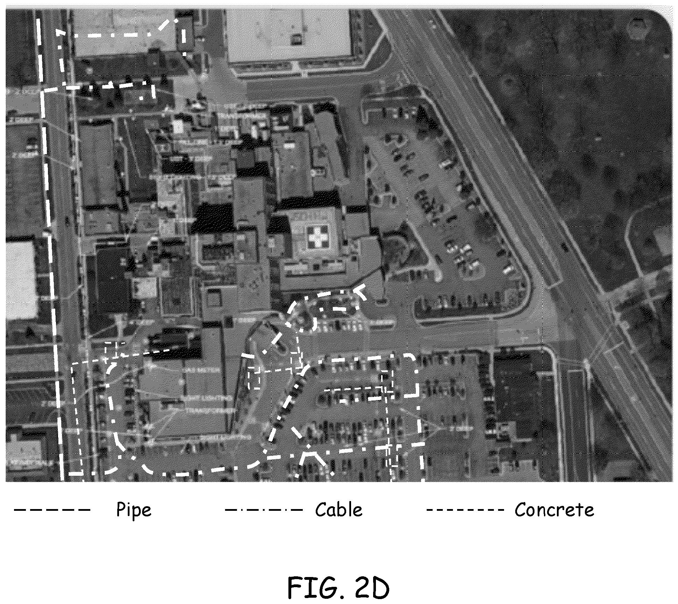

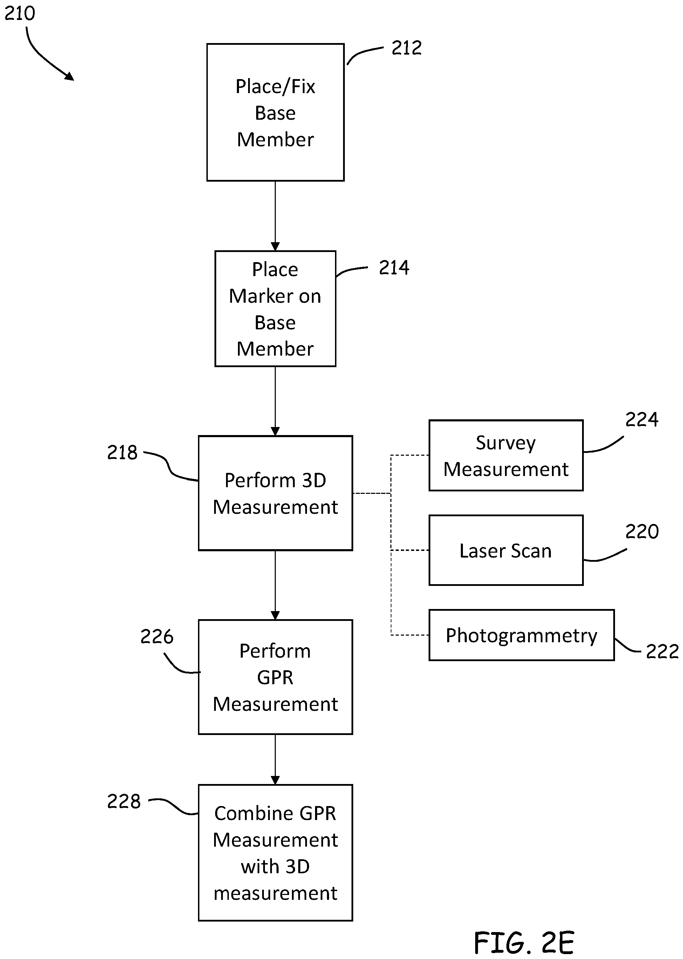

Referring now to FIG. 2D and FIG. 2E, with continuing reference to FIGS. 1A-1C, a method 210 is shown for combining 3D ground penetrating radar data with point cloud data to define a combined digital model. The method 210 begins in block 212 with the operator fixing the targets 204 in the area to be scanned by the 3D coordinate measurement device (e.g. laser scanner) and the coupling of markers 206 to each of the targets. As discussed herein, the target 204 includes a base member with a retaining element that allows the marker 206 to be coupled to the base member in block 214. In some embodiments, the marker 206 is fixed to the base member.

The method 210 then proceeds to block 218 where the 3D scan is performed to measure the above ground surfaces. The acquisition of this first plurality of 3D coordinates may be performed by any suitable measurement device, such as but not limited to a laser scanner 220, a triangulation scanner, a photogrammetry device 222, a surveying device (e.g. total station or theodolite) or a combination of the foregoing. In an embodiment, the position of each of the targets 204 may be measured by a surveying device in a geodesic frame of reference. The output of block 218 is a point cloud representing 3D coordinates of surfaces in the environment. As discussed herein, color information regarding the environment may be mapped to the 3D coordinates and the point cloud may be meshed to display the surfaces.

It should be appreciated that multiple 3D scans may be performed by the 3D coordinate measurement device to acquire a point cloud of the desired area. The point clouds from the individual scans may be registered to each other in a single frame of reference as is known in the art.

The method 210 then proceeds to block 226 where the GPR system 200 is moved in the target area, typically along straight lines. The targets 204 were placed in block 212 along these straight lines. The GPR system 200 includes a measurement head 227 (FIG. 2C) that is positioned in a fixed relationship to the ground 229. In an embodiment, the measurement head is a distance D from the ground 229 along a direction perpendicular to the ground 229. Thus as the GPR system 200 is moved along the line, when the measurement head 227 passes over a target 204 the target 204 will be distinguishable from the surrounding soil/materials 231 due to the difference in density between the two. Once the individual scans are performed, the GPR data may be combined into a single 3D GPR model. In an embodiment, the 3D GPR model includes a second plurality of 3D coordinates with associated density data in a GPR coordinate frame of reference.

The method 210 then proceeds to block 228 where the 3D GPR model and the first plurality of 3D coordinate data (in a first coordinate frame of reference) and the second plurality of 3D coordinate data (in a second or GPR coordinate frame of reference) are combined together based on the locations of the targets 204. In an embodiment, the registration or combining of the coordinate data and the GPR data is performed using a best fit or least squares technique.

As a result, a combined model is generated as shown in FIG. 2D which provides the technical effect of allowing the user to have access to both above ground structure information with the location of subterranean structures.

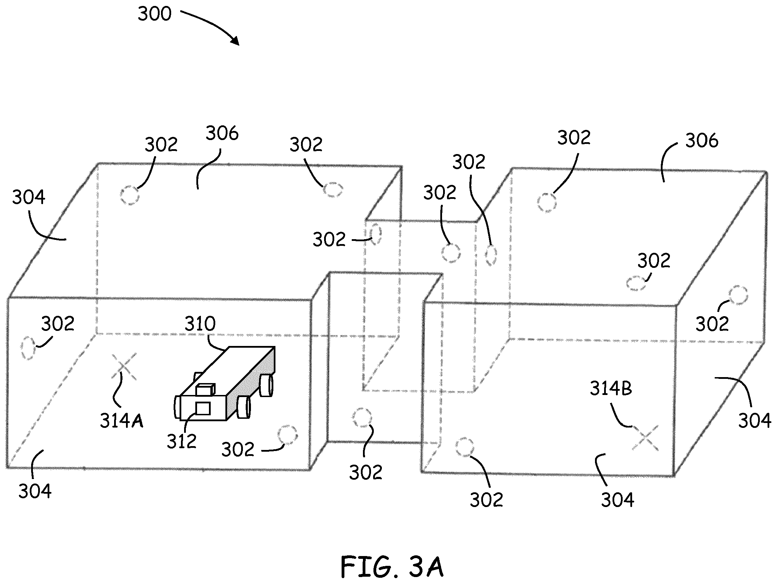

The combining of different 3D data sets may also be used for other purposes, such as the localization within an environment for example. Referring now to FIGS. 3A - 3C, another embodiment is shown of a system for localizing a automated guided vehicle 310 (AGV) within a facility 300. Arranged within the facility 300 are a plurality of targets 302 disposed on structures such as walls 304, and ceilings 306. As discussed herein, the target 302 includes a base member with a retaining element that allows a marker (e.g. a spherical checkerboard marker) to be removably coupled to the base member.

One issue that arises with AGV's 310 is one of localization. In a modern manufacturing environment the facility may change on a regular basis. Equipment may be moved, assembly lines changed, pallets of material added or moved for example. Therefore, any maps of the facility that are stored in the AGV's memory may be quickly outdated. Typically, the AGV 310 will have a laser ranging device 312 that prevents the AGV 310 from hitting into objects or people. The laser device 312 sweeps a beam of laser light in a plane and receives back a reflection of the light off of a surface to determine a distance and an angle to the surface. From this, the AGV 310 can use simultaneous localization and mapping (SLAM) techniques to generates a map of the environment. In some instances, the SLAM generated map is registered to a predetermined map stored in memory to allow the AGV 310 to determine its position in the facility 300.

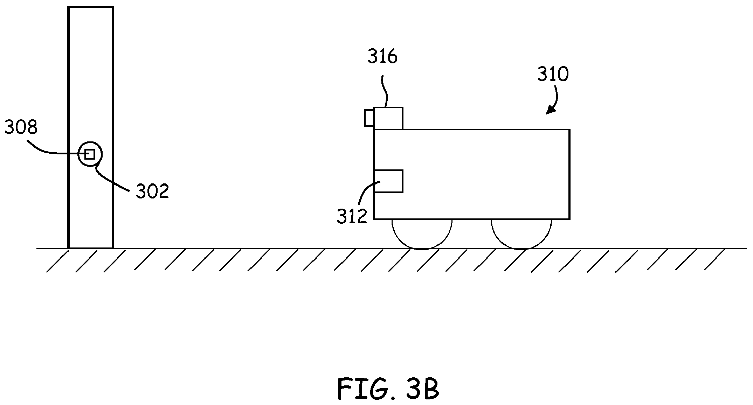

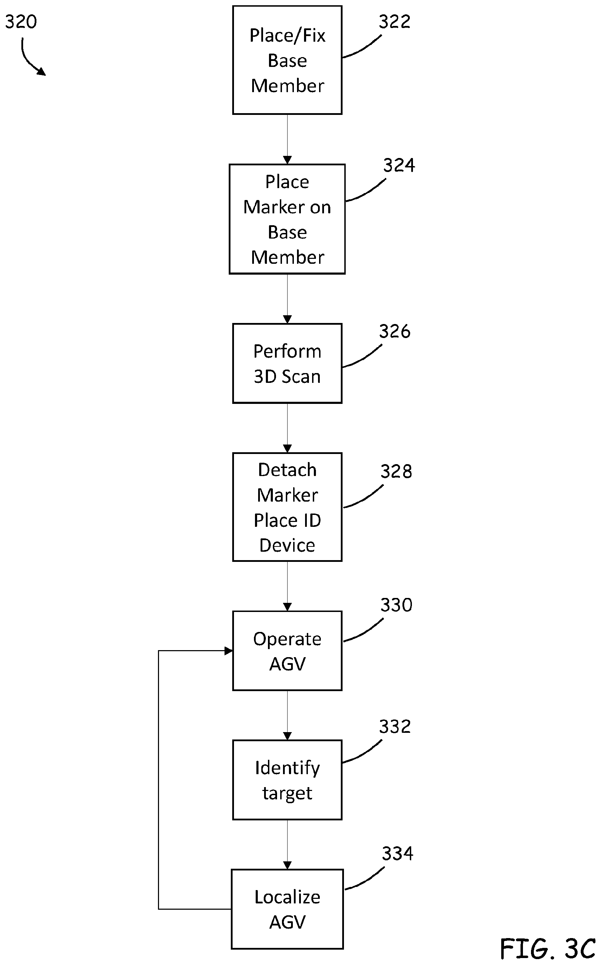

As mentioned above, due to the changing nature of the environment in the facility 310, in some instances the AGV 310 may lose its localization within the facility. Referring now to FIG. 3C, with continuing reference to FIG. 3A and FIG. 3B, a method 320 is shown for localizing an AGV 310 within a facility 300. The method 320 begins in block 322 where the targets 302 are fixed to structures within the facility 300. In an embodiment, the target 302 includes a base member having a retaining element that allows different devices to be coupled to the base member without moving the base member relative to the structure to which is it attached. The method 320 then proceeds to block 324 where a marker, such as a spherical photogrammetry marker for example, is coupled to the base member by the retaining element,

The method 320 then proceeds to block 326 where a 3D scan is performed by a 3D coordinate measurement device (e.g. a laser scanner or photogrammetry device) to generate a plurality of first 3D coordinates or a point cloud of the interior of the facility 300. In an embodiment, multiple scans may be performed to allow the facility to be fully measured without any substantial occlusions. For example in the facility 300, a scan may be performed at each of the points 314A, 314B. In an embodiment each of the targets 302 is assigned a unique identifier within the facility. This may be done for example by using coded markers. In other embodiments, the user may manually assign an identifier to the base member in the point cloud.

With the 3D scan performed, the method 320 then proceeds to block 328 where the marker is detached from the base member and an ID device 308 (FIG. 3B) is attached to the base member via the retaining element. In an embodiment, the ID device 308 includes a machine readable code, such as a QR code or a bar code for example, that is readable by a device such as a camera 316 on the AGV 310. The machine readable code includes or is associate with the identifier of the target 302. In an embodiment the ID device 308 may include an emitter that transmits radio frequency signals and rather than a camera 316, the AGV 310 includes a receiver. In still other embodiments, the AGV 310 includes an RFID transducer and the target 302 includes an RFID tag that includes the identifier of the target 302.

Once this has been completed for each of the targets 302 within the facility 300, the method 320 then proceeds to block 330 where the AGV 310 is operated. As the AGV 310 moves through the environment, the AGV 310 will acquire an image of a target 302 fixed on a structure. The method 320 then proceeds to block 332 where the unique identifier of the target 302 is determined. This may be done, for example, by processing the image of the QR code on the marker 308. With the marker 308 identified the method 320 proceeds to block 334 where the position of the AGV 310 is localized within the facility 300. In an embodiment, the localization is performed by determining the position in the point cloud acquired in block 326 by registering the relative position of the target 302 identified in block 332 with the target in the point cloud based at least in part on the identifier. In other words, the identifier determined in block 332 is located in point cloud and the relative position or pose of the AGV 310 is determined using either the laser device 312 or via image analysis from the image acquired by camera 316. The method 320 then loops back to block 330 and repeats.

It should be appreciated that the localization of the AGV 310 within the facility 300 on a periodic or aperiodic basis corrects for deviations or errors between the AGV's actual position and where the AGV thinks it is located, such as due to movement of equipment or goods within the facility 300 or due to drift for example.

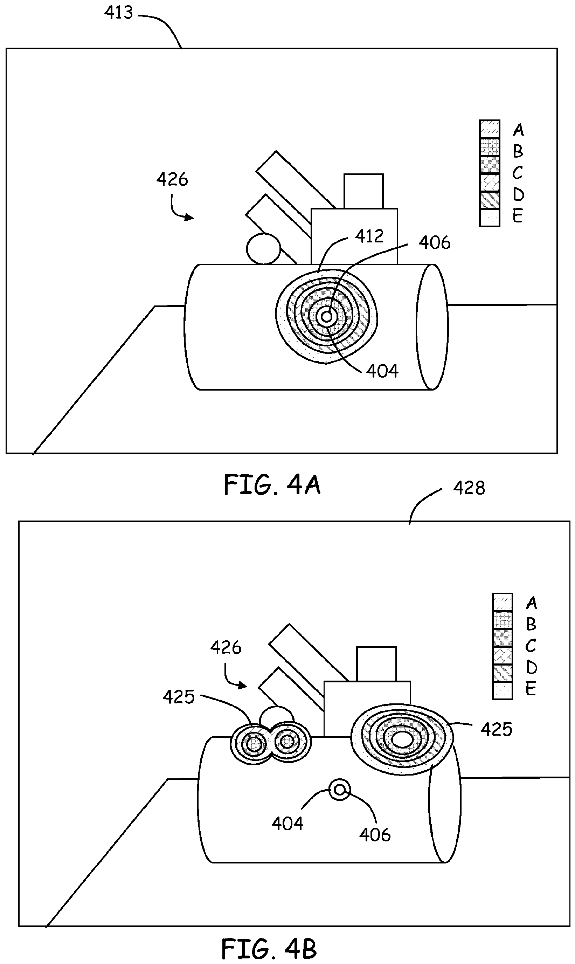

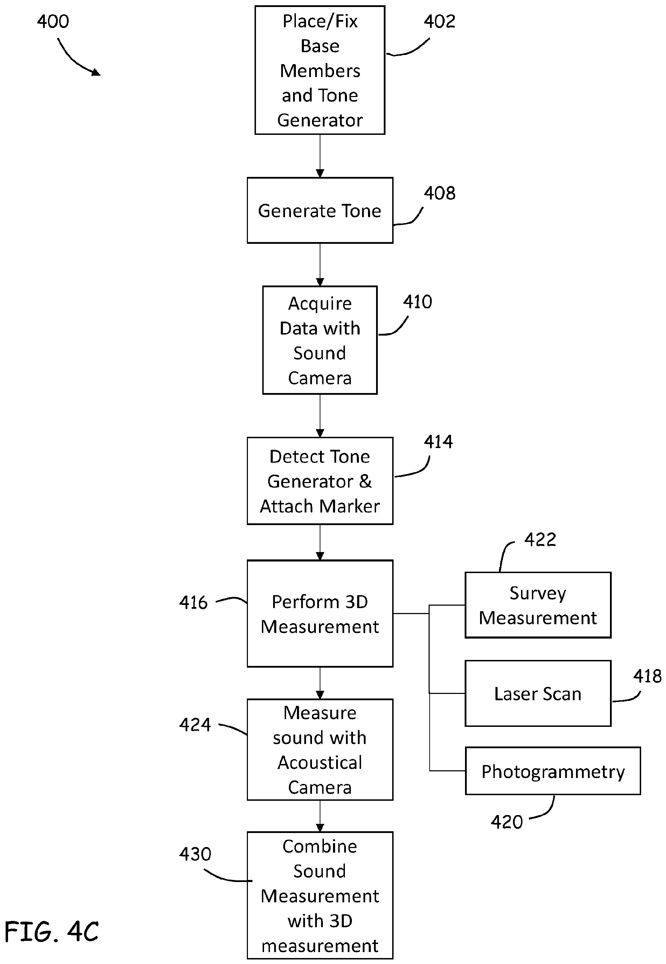

Sound pressure cameras or acoustical cameras are a measurement devices that are used to locate sound sources and to characterize them. The device consists of a group of microphones, also called a microphone array, from which signals are simultaneously collected and processed to form a graphical representation of the location of the sound sources as shown in FIG. 4A and FIG. 4B. While this sound information may be very useful to a planner, an architect, or an engineer, as with the previous embodiments, it is difficult to combine this physical measurement with point cloud data. Referring now to FIGS. 4A - 4C, an embodiment is shown of a method 400 for combining sound pressure level data into a point cloud.

The method 400 begins in block 402 where a target 404 comprised of a base member having a retaining element is coupled near the area where the sound measurements are to be performed. The retaining element is used to couple a tone generator 406 to the base member. As used herein, the tone generator may be any device that is capable of generating a sound. In an embodiment, the tone generator emits a substantially continuous and uniform sound. In an embodiment, the tone generator emits a sound at a predetermined frequency and predetermined sound level. The method 400 then proceeds to block 408 where the sound is generated by the tone generator and to block 410 where the sound levels are measured with an acoustical camera. An example of an image generated by the acoustical camera is shown in FIG. 4A. It should be appreciated that the sound emitted by the tone generator 406 results in a generally circular pattern 412 in the two-dimensional (2D) image 413 acquired by the acoustical camera. As a result, the center of the target 404 can be determined based on the pattern 412 in block 414. It should be appreciated that while only a single target/tone-generator is shown, this is for example purposes and blocks 402-414 may be repeated multiple times or a single image with multiple tone generators emitting sound simultaneously. In an embodiment, at least three different tone generator measurements are performed.

In block 414, after detecting the tone generator 406 in the image 413, the tone generator 406 is removed and replaced with a marker, such as a spherical photogrammetry marker or checkerboard marker for example. With the marker in place, the method 400 proceeds to block 416 where the 3D measurement of the environment is performed, such as with a laser scanner 418 or photogrammetry device 420, or with a surveying device 422 such as a total station or theodolite as described herein. It should be appreciated that the 3D measurement will also measure the position of the marker attached to the target 404. Thus the center of the target 404 may be determined in the resulting 3D point cloud. It should be appreciated that when multiple tone generators are used in blocks 402-414, the pose of the acoustical camera, and the locations where the tone generators were positioned may be determined.

The method 400 then proceeds to block 424 where the acoustical camera is used to measure sound levels 425 in the environment, such as from operating equipment 426. This results in a 2D image 428 as shown in FIG. 4B. Since the position of the tone generators is known, and the pose of the acoustical camera is known, the sound measurement levels from the 2D image 428 may be mapped onto the 3D point cloud in block 430. In an embodiment, this mapping is performed in a similar manner to texture information acquired by a 3D coordinate measurement device is mapped onto a point cloud.

It should be appreciated that while embodiments herein describe the combining of a single physical measurement parameter with a point cloud, this is for example purposes and the claims should not be so limited. In other embodiments, multiple physical parameters may be combined into the point cloud, such as but not limited to ground penetrating radar and sound levels (e.g. for city planning), or sonar data with ground penetrating radar (e.g. for remediation), or a combination of sonar, sound levels, and ground penetrating radar. Further, it is contemplated that other physical parameters, such as temperature may also be incorporated or mapped into a single point cloud model. This model may store the physical parameter data in different layers such that the physical parameter data may be selectively displayed.

Referring now to FIGS. 5A - 5D, an embodiment of a laser scanner 520 is shown that may be used to acquire the 3D coordinate measurements that were described with respect to any of the embodiments herein. It should be appreciated that while the laser scanner 520 is shown, this is for example purposes and any suitable 3D coordinate measurement device may be used to generate a point cloud or determine the position of the targets in the environment.

The laser scanner 520 has a measuring head 522 and a base 524. The measuring head 522 is mounted on the base 524 such that the laser scanner 520 may be rotated about a vertical axis 523. In one embodiment, the measuring head 522 includes a gimbal point 527 that is a center of rotation about the vertical axis 523 and a horizontal axis 525. The measuring head 522 has a rotary mirror 526, which may be rotated about the horizontal axis 525. The rotation about the vertical axis may be about the center of the base 524. The terms vertical axis and horizontal axis refer to the scanner in its normal upright position. It is possible to operate a 3D coordinate measurement device on its side or upside down, and so to avoid confusion, the terms azimuth axis and zenith axis may be substituted for the terms vertical axis and horizontal axis, respectively. The term pan axis or standing axis may also be used as an alternative to vertical axis.

The measuring head 522 is further provided with an electromagnetic radiation emitter, such as light emitter 528, for example, that emits an emitted light beam 530. In one embodiment, the emitted light beam 530 is a coherent light beam such as a laser beam. The laser beam may have a wavelength range of approximately 300 to 1600 nanometers, for example 790 nanometers, 905 nanometers, 1550 nm, or less than 400 nanometers. It should be appreciated that other electromagnetic radiation beams having greater or smaller wavelengths may also be used. The emitted light beam 530 is amplitude or intensity modulated, for example, with a sinusoidal waveform or with a rectangular waveform. The emitted light beam 530 is emitted by the light emitter 528 onto a beam steering unit, such as mirror 526, where it is deflected to the environment. A reflected light beam 532 is reflected from the environment by an object 534. The reflected or scattered light is intercepted by the rotary mirror 526 and directed into a light receiver 536. The directions of the emitted light beam 530 and the reflected light beam 532 result from the angular positions of the rotary mirror 526 and the measuring head 522 about the axes 525 and 523, respectively. These angular positions in turn depend on the corresponding rotary drives or motors.

Coupled to the light emitter 528 and the light receiver 536 is a controller 538. The controller 538 determines, for a multitude of measuring points X, a corresponding number of distances d between the laser scanner 520 and the points X on object 5534. The distance to a particular point X is determined based at least in part on the speed of light in air through which electromagnetic radiation propagates from the device to the object point X. In one embodiment the phase shift of modulation in light emitted by the laser scanner 520 and the point X is determined and evaluated to obtain a measured distance d.

The speed of light in air depends on the properties of the air such as the air temperature, barometric pressure, relative humidity, and concentration of carbon dioxide. Such air properties influence the index of refraction n of the air. The speed of light in air is equal to the speed of light in vacuum c divided by the index of refraction. In other words, cair = c / n. A laser scanner of the type discussed herein is based on the time-of-flight (TOF) of the light in the air (the round-trip time for the light to travel from the device to the object and back to the device). Examples of TOF scanners include scanners that measure round trip time using the time interval between emitted and returning pulses (pulsed TOF scanners), scanners that modulate light sinusoidally and measure phase shift of the returning light (phase-based scanners), as well as many other types. A method of measuring distance based on the time-of-flight of light depends on the speed of light in air and is therefore easily distinguished from methods of measuring distance based on triangulation. Triangulation-based methods involve projecting light from a light source along a particular direction and then intercepting the light on a camera pixel along a particular direction. By knowing the distance between the camera and the projector and by matching a projected angle with a received angle, the method of triangulation enables the distance to the object to be determined based on one known length and two known angles of a triangle. The method of triangulation, therefore, does not directly depend on the speed of light in air.

In one mode of operation, the scanning of the volume around the laser scanner 520 takes place by rotating the rotary mirror 526 relatively quickly about axis 525 while rotating the measuring head 522 relatively slowly about axis 523, thereby moving the assembly in a spiral pattern. In an exemplary embodiment, the rotary mirror rotates at a maximum speed of 5820 revolutions per minute. For such a scan, the gimbal point 527 defines the origin of the local stationary reference system. The base 524 rests in this local stationary reference system.

In addition to measuring a distance d from the gimbal point 527 to an object point X, the scanner 520 may also collect gray-scale information related to the received optical power (equivalent to the term "brightness") The gray-scale value may be determined at least in part, for example, by integration of the bandpass-filtered and amplified signal in the light receiver 536 over a measuring period attributed to the object point X.

The measuring head 522 may include a display device 540 integrated into the laser scanner 520. The display device 540 may include a graphical touch screen 541, as shown in FIG. 5A, which allows the operator to set the parameters or initiate the operation of the laser scanner 520. For example, the screen 541 may have a user interface that allows the operator to provide measurement instructions to the device, and the screen may also display measurement results.

The laser scanner 520 includes a carrying structure 542 that provides a frame for the measuring head 522 and a platform for attaching the components of the laser scanner 520. In one embodiment, the carrying structure 542 is made from a metal such as aluminum. The carrying structure 542 includes a traverse member 544 having a pair of walls 546, 548 on opposing ends. The walls 546, 548 are parallel to each other and extend in a direction opposite the base 524. Shells 550, 552 are coupled to the walls 546, 548 and cover the components of the laser scanner 520. In the exemplary embodiment, the shells 550, 552 are made from a plastic material, such as polycarbonate or polyethylene for example. The shells 550, 552 cooperate with the walls 546, 548 to form a housing for the laser scanner 520.

On an end of the shells 550, 552 opposite the walls 546, 548 a pair of yokes 554, 556 are arranged to partially cover the respective shells 50, 52. In the exemplary embodiment, the yokes 554, 556 are made from a suitably durable material, such as aluminum for example, that assists in protecting the shells 550, 552 during transport and operation. The yokes 554, 556 each includes a first arm portion 558 that is coupled, such as with a fastener for example, to the traverse 544 adjacent the base 524. The arm portion 558 for each yoke 554, 556 extends from the traverse 544 obliquely to an outer corner of the respective shell 550, 552. From the outer corner of the shell, the yokes 554, 556 extend along the side edge of the shell to an opposite outer corner of the shell. Each yoke 554, 556 further includes a second arm portion that extends obliquely to the walls 546, 548. It should be appreciated that the yokes 554, 556 may be coupled to the traverse 542, the walls 546, 548 and the shells 550, 554 at multiple locations.

The pair of yokes 554, 556 cooperate to circumscribe a convex space within which the two shells 550, 552 are arranged. In the exemplary embodiment, the yokes 554, 556 cooperate to cover all of the outer edges of the shells 550, 554, while the top and bottom arm portions project over at least a portion of the top and bottom edges of the shells 550, 552. This provides advantages in protecting the shells 550, 552 and the measuring head 522 from damage during transportation and operation. In other embodiments, the yokes 554, 556 may include additional features, such as handles to facilitate the carrying of the laser scanner 520 or attachment points for accessories for example.

On top of the traverse 544, a prism 560 is provided. The prism extends parallel to the walls 546, 548. In the exemplary embodiment, the prism 560 is integrally formed as part of the carrying structure 542. In other embodiments, the prism 560 is a separate component that is coupled to the traverse 544. When the mirror 526 rotates, during each rotation the mirror 526 directs the emitted light beam 530 onto the traverse 544 and the prism 560. Due to non-linearities in the electronic components, for example in the light receiver 536, the measured distances d may depend on signal strength, which may be measured in optical power entering the scanner or optical power entering optical detectors within the light receiver 536, for example. In an embodiment, a distance correction is stored in the scanner as a function (possibly a nonlinear function) of distance to a measured point and optical power (generally unscaled quantity of light power sometimes referred to as "brightness") returned from the measured point and sent to an optical detector in the light receiver 536. Since the prism 560 is at a known distance from the gimbal point 527, the measured optical power level of light reflected by the prism 560 may be used to correct distance measurements for other measured points, thereby allowing for compensation to correct for the effects of environmental variables such as temperature. In the exemplary embodiment, the resulting correction of distance is performed by the controller 538.

In an embodiment, the base 524 is coupled to a swivel assembly (not shown) such as that described in commonly owned U.S. Patent No. 8,705,012 ('012), which is incorporated by reference herein. The swivel assembly is housed within the carrying structure 542 and includes a motor 638 that is configured to rotate the measuring head 522 about the axis 523. In an embodiment, the angular/rotational position of the measuring head 522 about the axis 523 is measured by angular encoder 634.

An auxiliary image acquisition device 566 may be a device that captures and measures a parameter associated with the scanned area or the scanned object and provides a signal representing the measured quantities over an image acquisition area. The auxiliary image acquisition device 566 may be, but is not limited to, a pyrometer, a thermal imager, an ionizing radiation detector, or a millimeter-wave detector. In an embodiment, the auxiliary image acquisition device 566 is a color camera.

In an embodiment, a central color camera (first image acquisition device) 612 is located internally to the scanner and may have the same optical axis as the 3D scanner device. In this embodiment, the first image acquisition device 612 is integrated into the measuring head 522 and arranged to acquire images along the same optical pathway as emitted light beam 530 and reflected light beam 532. In this embodiment, the light from the light emitter 528 reflects off a fixed mirror 616 and travels to dichroic beam-splitter 618 that reflects the light 617 from the light emitter 528 onto the rotary mirror 526. In an embodiment, the mirror 526 is rotated by a motor 636 and the angular/rotational position of the mirror is measured by angular encoder 634. The dichroic beam-splitter 618 allows light to pass through at wavelengths different than the wavelength of light 617. For example, the light emitter 528 may be a near infrared laser light (for example, light at wavelengths of 780 nm or 1150 nm), with the dichroic beam-splitter 618 configured to reflect the infrared laser light while allowing visible light (e.g., wavelengths of 400 to 700 nm) to transmit through. In other embodiments, the determination of whether the light passes through the beam-splitter 618 or is reflected depends on the polarization of the light. The digital camera 612 obtains 2D images of the scanned area to capture color data to add to the scanned image. In the case of a built-in color camera having an optical axis coincident with that of the 3D scanning device, the direction of the camera view may be easily obtained by simply adjusting the steering mechanisms of the scanner - for example, by adjusting the azimuth angle about the axis 523 and by steering the mirror 526 about the axis 525.

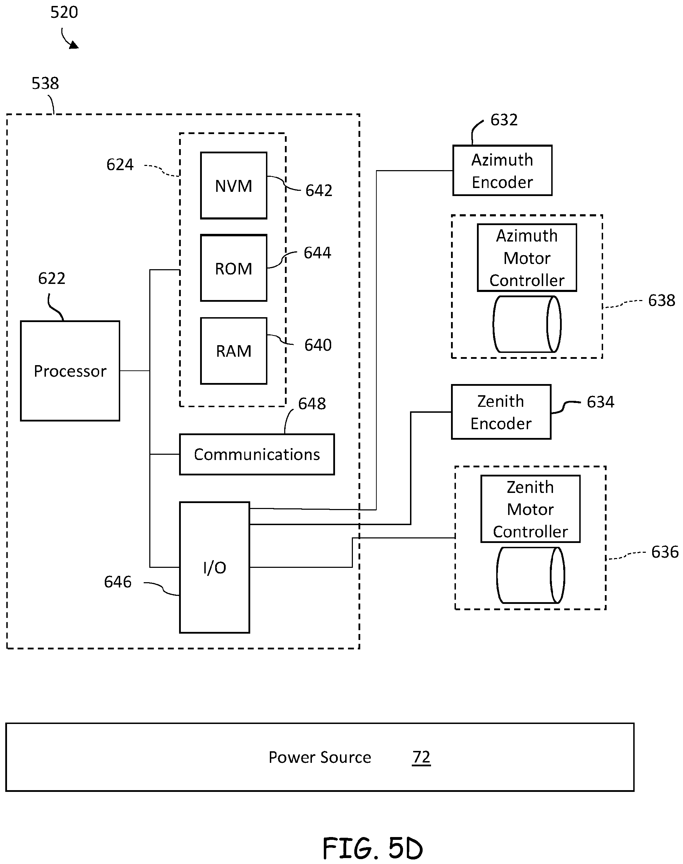

Referring now to FIG. 5D with continuing reference to FIGS. 5A-5C, elements are shown of the laser scanner 520. Controller 538 is a suitable electronic device capable of accepting data and instructions, executing the instructions to process the data, and presenting the results. The controller 538 includes one or more processing elements 622. The processors may be microprocessors, field programmable gate arrays (FPGAs), digital signal processors (DSPs), and generally any device capable of performing computing functions. The one or more processors 622 have access to memory 624 for storing information.

Controller 538 is capable of converting the analog voltage or current level provided by light receiver 536 into a digital signal to determine a distance from the laser scanner 520 to an object in the environment. Controller 538 uses the digital signals that act as input to various processes for controlling the laser scanner 520. The digital signals represent one or more laser scanner 520 data including but not limited to distance to an object, images of the environment, images acquired by panoramic camera 626, angular/rotational measurements by a first or azimuth encoder 632, and angular/rotational measurements by a second axis or zenith encoder 634.

In general, controller 538 accepts data from encoders 632, 634, light receiver 5536, light source 528, and panoramic camera 626 and is given certain instructions for the purpose of generating a 3D point cloud of a scanned environment. Controller 538 provides operating signals to the light source 528, light receiver 536, panoramic camera 626, zenith motor 636 and azimuth motor 638. The controller 538 compares the operational parameters to predetermined variances and if the predetermined variance is exceeded, generates a signal that alerts an operator to a condition. The data received by the controller 538 may be displayed on a user interface 540 coupled to controller 538. The user interface 540 may be one or more LEDs (light-emitting diodes), an LCD (liquid-crystal diode) display, a CRT (cathode ray tube) display, a touch-screen display or the like. A keypad may also be coupled to the user interface for providing data input to controller 538. In one embodiment, the user interface is arranged or executed on a mobile computing device that is coupled for communication, such as via a wired or wireless communications medium (e.g. Ethernet, serial, USB, Bluetooth^{™} or WiFi) for example, to the laser scanner 5520.

The controller 538 may also be coupled to external computer networks such as a local area network (LAN) and the Internet. A LAN interconnects one or more remote computers, which are configured to communicate with controller 538 using a well- known computer communications protocol such as TCP/IP (Transmission Control Protocol/Internet(^) Protocol), RS-232, ModBus, and the like. Additional systems 520 may also be connected to LAN with the controllers 538 in each of these systems 520 being configured to send and receive data to and from remote computers and other systems 520. The LAN may be connected to the Internet. This connection allows controller 538 to communicate with one or more remote computers connected to the Internet.

The processors 622 are coupled to memory 624. The memory 624 may include random access memory (RAM) device 640, a non-volatile memory (NVM) device 642, and a read-only memory (ROM) device 644. In addition, the processors 622 may be connected to one or more input/output (I/O) controllers 646 and a communications circuit 648. In an embodiment, the communications circuit 648 provides an interface that allows wireless or wired communication with one or more external devices or networks, such as the LAN discussed above.

Controller 538 includes operation control methods embodied in application code shown in FIG. 1D, 2E, 3C and FIG. 4C. These methods are embodied in computer instructions written to be executed by processors 622, typically in the form of software. The software can be encoded in any language, including, but not limited to, assembly language, VHDL (Verilog Hardware Description Language), VHSIC HDL (Very High Speed IC Hardware Description Language), Fortran (formula translation), C, C++, C#, Objective-C, Visual C++, Java, ALGOL (algorithmic language), BASIC (beginners all-purpose symbolic instruction code), visual BASIC, ActiveX, HTML (HyperText Markup Language), Python, Ruby and any combination or derivative of at least one of the foregoing.

The term "about" is intended to include the degree of error associated with measurement of the particular quantity based upon the equipment available at the time of filing the application. For example, "about" can include a range of ± 8% or 5%, or 2% of a given value.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof. It should also be noted that the terms "first", "second", "third", "upper", "lower", and the like may be used herein to modify various elements. These modifiers do not imply a spatial, sequential, or hierarchical order to the modified elements unless specifically stated.

While the disclosure is provided in detail in connection with only a limited number of embodiments, it should be readily understood that the disclosure is not limited to such disclosed embodiments. Rather, the disclosure can be modified to incorporate any number of variations, alterations, substitutions or equivalent arrangements not heretofore described, but which are commensurate with the spirit and scope of the disclosure. Additionally, while various embodiments of the disclosure have been described, it is to be understood that the exemplary embodiment(s) may include only some of the described exemplary aspects. Accordingly, the disclosure is not to be seen as limited by the foregoing description, but is only limited by the scope of the appended claims.

## Claims

1. A method for generating a three-dimensional (3D) model of an environment, the method comprising:
acquiring a first plurality of 3D coordinates of surfaces in the environment in a first coordinate frame of reference using a first measurement device, the first plurality of 3D coordinates including at least one subset of 3D coordinates of a target, the first measurement device optically measuring the plurality of 3D coordinates;
acquiring a second plurality of 3D coordinates of the environment in a second frame of reference using a second measurement device, the second plurality of 3D coordinates including at least one physical parameter, the second measurement device being operably disposed in a fixed relationship to the target; and
registering the second plurality of 3D coordinates with the first plurality of 3D coordinates in the first coordinate frame of reference based at least in part on the at least one subset of 3D coordinates and the fixed relationship.

2. The method of claim 1, wherein the second measurement device is a sonar measurement device that is rigidly coupled to and offset from the target.

3. The method of claim 1, wherein:
the target is fixed to a ground surface in the environment;
the second measurement device is a ground penetrating radar device that is configured to measure a distance to the target when the ground penetrating radar is moved over the target; and
the fixed relationship is the distance.

4. The method of claim 3, wherein the physical parameter is measured by the ground penetrating radar.

5. The method of claim 4, wherein the first frame of reference is a geodetic frame of reference and the first measurement device is one of a theodolite, a total station, a laser tracker or a laser scanner.

6. The method of claim 1, wherein the second measurement device is a sound pressure camera and the target includes a tone generator.

7. The method of claim 6, wherein the acquiring of the second plurality of 3D coordinates includes:
generating sound at a predetermined frequency and level with the tone generator;
acquiring a third plurality of 3D coordinates of the target in the second coordinate frame of reference with the sound pressure camera based on the sound;
acquiring a fourth plurality of 3D coordinates of the environment in the second coordinate frame of reference with the sound pressure camera, at least a portion of the fourth plurality of 3D coordinates having an associated sound pressure level value; and
registering the third plurality of 3D coordinates and the fourth plurality of 3D coordinates in the second frame of reference.

8. The method of claim 7, further comprising:
coupling a marker to a retaining element of the target prior to acquiring the first plurality of 3D coordinates;
removing the marker from the retaining element and coupling the tone generator to the retaining element prior to acquiring the third plurality of 3D coordinates; and
deactivating the tone generator prior to acquiring the fourth plurality of 3D coordinates.

9. A method for generating a three-dimensional (3D) model of an environment, the method comprising:
providing a first measurement device configured to optically measuring a plurality of 3D coordinates;
acquiring the first plurality of 3D coordinates in a first coordinate frame of reference using the first measurement device, the first plurality of 3D coordinates including at least one subset of 3D coordinates of a target;
providing a second measurement device configured to measure a second plurality of 3D coordinates that include at least one physical parameter;
disposing the second measurement device in a fixed relationship to the target;
acquiring the second plurality of 3D coordinates in a second frame of reference using the second measurement device; and
registering the second plurality of 3D coordinates with the first plurality of 3D coordinates in the first coordinate frame of reference based at least in part on the at least one subset of 3D coordinates and the fixed relationship.

10. The method of claim 9, wherein the second measurement device is a sonar measurement device that is rigidly coupled to and offset from the target.

11. The method of claim 9, wherein:
the target is fixed to a ground surface in the environment;
the second measurement device is a ground penetrating radar device that is configured to measure a distance to the target when the ground penetrating radar is moved over the target; and
the fixed relationship is the distance.

12. The method of claim 11, wherein the physical parameter is measured by the ground penetrating radar.

13. The method of claim 12, wherein the first frame of reference is a geodetic frame of reference and the first measurement device is one of a theodolite, a total station, a laser tracker or a laser scanner.

14. The method of claim 9, wherein the second measurement device is a sound pressure camera and the target includes a tone generator.

15. The method of claim 14, further comprising:
wherein the acquiring of the second plurality of 3D coordinates includes:
generating sound at a predetermined frequency and level with the tone generator;
acquiring a third plurality of 3D coordinates of the target in the second coordinate frame of reference with the sound pressure camera based on the sound;
acquiring a fourth plurality of 3D coordinates of the environment in the second coordinate frame of reference with the sound pressure camera, at least a portion of the fourth plurality of 3D coordinates having an associated sound pressure level value; and
registering the third plurality of 3D coordinates and the fourth plurality of 3D coordinates in the second frame of reference;
wherein the target is includes a base having a retaining element;
coupling a marker to the retaining element prior to acquiring the first plurality of 3D coordinates;
removing the marker from the retaining element and coupling the tone generator to the retaining element prior to acquiring the third plurality of 3D coordinates; and
deactivating the tone generator prior to acquiring the fourth plurality of 3D coordinates.
